# EUROPÄISCHE PATENTSCHRIFT

(11) **EP 0 735 672 B1**
(45) Veröffentlichungstag und Bekanntmachung des Hinweises auf die Patenterteilung: **27.11.2002**
(21) Anmeldenummer: 96104184.5
(22) Anmeldetag: 15.03.1996
(51) Int. Cl.: H03H 9/64, H03H 9/145, H04N 5/44, H03H 9/72

(54) **Oberflächenwellen-Doppelwandler für ein Doppelfilter, insbesondere für Fernsehempfangsgeräte**
Dual surface acoustic wave transducer for dual filter, in particular for television receivers
Transducteur double à ondes acoustiques de surface pour filtre double, notamment pour récepteurs de télévision

(30) Priorität: 31.03.1995 DE 19512251
(43) Veröffentlichungstag der Anmeldung: 02.10.1996
(73) Patentinhaber: EPCOS AG, 81541 München (DE)
(72) Erfinder: Fischerauer, Alice, Dipl.-Ing., 85652 Pliening (DE)
(74) Vertreter: Epping, Wilhelm, Dipl.-Ing.

(56) Entgegenhaltungen:
- EP-A- 0 111 978
- GB-A- 2 123 637
- US-A- 5 309 057

## Beschreibung

Die vorliegende Erfindung betrifft einen Doppelwandler, geeignet für ein Doppelfilter, wie es insbesondere in Fernsehempfangsgeräten als einziges Kanalfilter anstelle von bisher jeweils zwei verwendeten Kanalfiltern einzusetzen ist.

In Fernsehempfangsgeräten werden dem Stand der Technik nach Fernsehkanalfilter verwendet, die zusammen mit dem Hochfrequenzsignal eines abstimmbaren Oszillators der vom Fernsehzuschauer vorzunehmenden Auswahl eines gewünschten Fernsehkanals dienen. Es ist seit Jahrzehnten bekannt, solche Fernsehfilter zu verwenden, die in Oberflächenwellentechnik aufgebaut sind.

Die zu empfangenden Fernsehsignale der den einzelnen Fernsehsendern zugeordneten Fernsehkanäle haben bestimmte genormte Charakteristika. Diese Normung ist aber nicht einmal europaweit einheitlich, z.B. bedingt durch die verschiedenen Kanal-Bandbreiten beispielsweise in Deutschland und Frankreich. Auch ist normiert vorgegebenes verschiedenes Durchlaßverhalten der Kanalfilter verschiedener Normen vorgesehen.

Für z.B. Zwei-Normen-Empfänger werden dem Stand der Technik nach zwei verschiedene Oberflächenwellenfilter als jeweiliges Kanalfilter der einen und der anderen Norm verwendet. Solche Zweikanalfilter sind bekannterweise auf einem Substratplättchen nebeneinander angeordnet. Im wesentlichen wird damit jedoch fast soviel Substratmaterial benötigt, wie für zwei einzelne getrennte Filter zusammengenommen erforderlich ist. Die bekannte Zusammenfassung zweier Kanalfilter für verschiedene Normen auf einem etwa doppelt so großen Substratkörper dient im wesentlichen der Vereinfachung der Montage des Filters und dergleichen.

Aus der GB-A-2 123 637 ist ein Oberflächenwellenfilter mit einem Interdigitalwandler bekannt, der mehrere Gruppen von Elektrodenfingern aufweist, die in transversaler Richtung gesehen nebeneinander angeordnete Überlappungsbereiche bilden.

Aufgabe der vorliegenden Erfindung ist es, einen Wandler für einen Oberflächenwellenfilter anzugeben, mit dem eine Einsparung an Substratmaterial erzielt werden kann, ohne sonstige Vorteile der bisherigen Technik aufgeben zu müssen.

Diese Aufgabe wird mit einem Wandler nach Anspruch 1 gelöst. Weitere Ausgestaltungen und Weiterbildungen der Erfindung gehen aus Unteransprüchen hervor.

Ein Doppelfilter mit einem erfindungsgemäßen Oberflächenwellenwandler hat die Eigenschaft, daß es als Kanalfilter die Forderungen zweier verschiedener Fernsehnormen in einem einzigen Filter vereint.

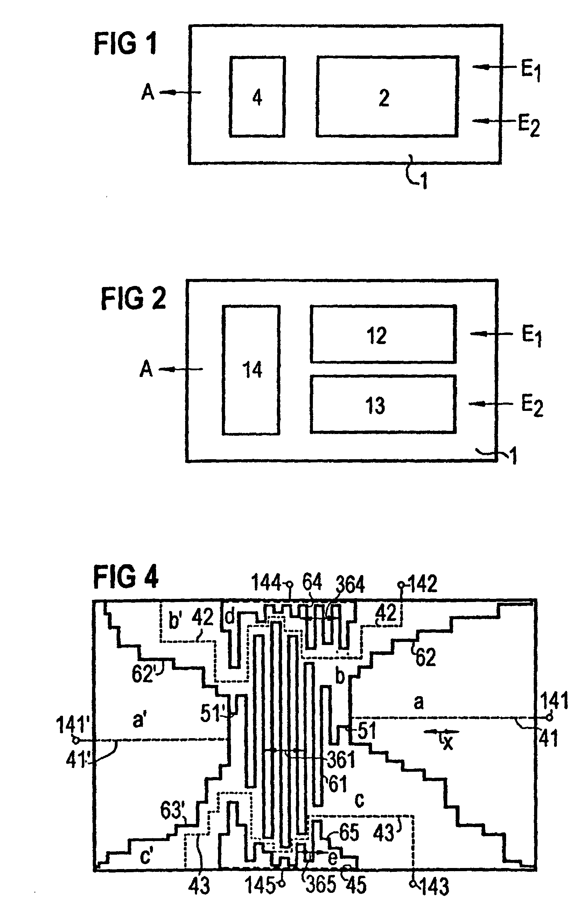

Weitere Erläuterungen zum Stand der Technik (Figur 2) und zur Erfindung (Figur 1) werden anhand der Figuren gegeben.
- Figur 1: zeigt ein erfindungsgemäßes Filter.
- Figur 2: zeigt ein Filter des Standes der Technik.
- Figur 3: zeigt ein Beispiel eines erfindungsgemäßen Wandlerdesigns und
- Figur 4: zeigt eine schematische Ansicht der Mäanderstruktur der Überlappungsverteilungen des Beispiels der Figur 3.

Das in Figur 2 gezeigte Filter des Standes der Technik umfaßt auf piezoelektrischem Material, insbesondere einem Substrat 11, zwei interdigitale Wandler 12 und 13. Diese beiden Wandler sind wie dargestellt nebeneinander auf dem Substrat plaziert. Sie dienen als Eingangswandler mit den Eingängen E1 und E2 für Fernseh-Eingangssignale zweier verschiedener Fernsehnormen. Über einen geräteinternen elektronischen Schalter, der den Eingängen E1 und E2 vorausgehend angeordnet ist, läßt sich das gesamte Eingangssignal der Antenne zeitlich umschaltbar entweder auf den einen Eingang E1 oder den anderen Eingang E2 legen. Der eine Wandler 12 ist auf das Eingangssignal der einen Norm und der andere Wandler 13 ist auf das Eingangssignal der anderen Norm angepaßt konzipiert. Der eine Wandler 12 erzeugt seiner Wandlerstruktur entsprechend eine akustische Welle. Diese wird im für beide Eingangsfilter 12, 13 gemeinsamen Ausgangswandler 14 in ein elektrisches Signal zurückumgewandelt, das die von der Seite des Empfangsgerätes her geforderte Form hat, daß das Fernsehbild des gewählten Kanals auf dem Bildschirm korrekt wiedergegeben zu sehen ist. Dies gilt sinngemäß für das Eingangssignal am Eingang E2 des zweiten Wandlers 13.

Da es sich hier um den Stand der Technik handelt, genügt es, dieses Prinzip durch die in Figur 2 dargestellten Rechtecke wiederzugeben.

In etwa dem gleichen Maßstab wie Figur 2 zeigt die Figur 1 ein Prinzipbild eines Doppelfilters mit einem erfindungsgemäßen Wandler mit den wiederum wahlweise schaltbaren Eingängen E1 und E2 in der "Doppelfunktion" als Eingangswandler 2 und dem Ausgangswandler 4. Diese Bestandteile des erfindungsgemäßen Filters sind auf einem piezoelektrischen Substratplättchen 1 aufgebracht. Dieses Plättchen 1 kann, wie ein Vergleich der Figuren 1 und 2 zeigt, erheblich kleiner sein als das Substratplättchen 11 der bekannten Filterkombination nach Figur 2.

Es sei darauf hingewiesen, daß die Größe/Menge des verwendeten einkristallinen Substratmaterials ein wesentlicher Kostenfaktor für ein derartiges Filter wie es die Erfindung betrifft ist. Ein weiterer wesentlicher Kostenfaktor ist das hermetisch abgedichtete Gehäuse des Filters. Für ein mit der Erfindung ermöglichtes kleineres Substrat genügt ein preisgünstigeres kleineres Gehäuse, ohne das, und dies ist ebenfalls bedeutsam, höhere Einfügungsdämpfung in Kauf zu nehmen wäre.

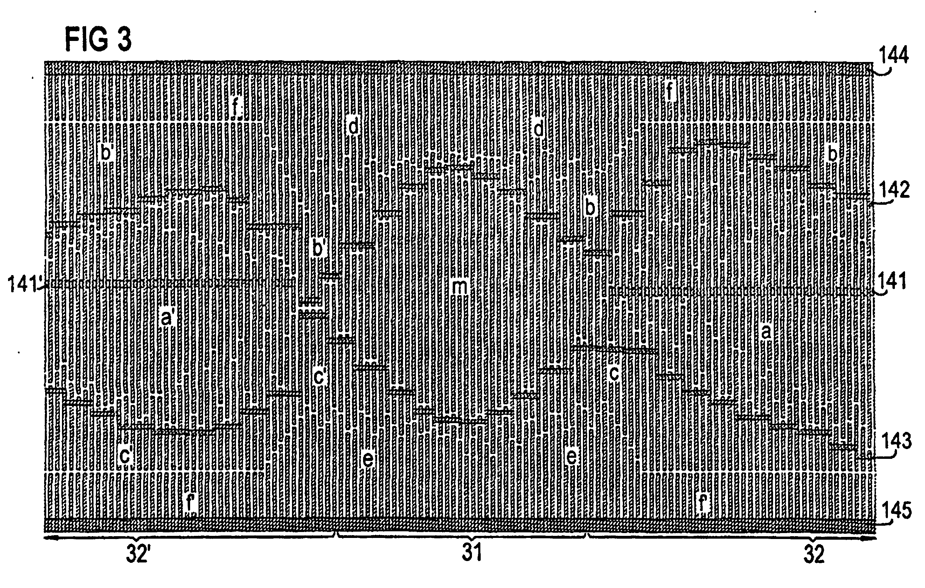

Das die Realisierung der Erfindung ermöglichende Design der Wandlerstruktur des "Doppelfunktions" (Eingangs-)Wandlers 2 wird anhand der Figuren 3 und 4 näher beschrieben. Die Figur 3 zeigt als Beispiel einen wesentlichen Ausschnitt der Fingerstruktur bzw. des Designs eines erfindungsgemäßen Eingangswandlers 2 eines Filters, das z.B. für Fernsehempfänger für den Empfang von Fernsehkanälen verschiedener, z.B. deutscher und französischer Norm vorteilhaft verwendbar ist.

Das erfindungsgemäße Design der Struktur des Eingangswandlers 2 eines Filters läßt sich funktionsmäßig in drei Anteile aufgeteilt beschreiben. Diese erstrecken sich in der Hauptausbreitungsrichtung der akustischen Welle benachbart. Zu dieser axialen Ausbreitungsrichtung sind die Finger der Struktur rechtwinklig orientiert ausgerichtet. Der mittlere Anteil 31 des Wandlers 2 umfaßt den für das integrale Dämpfungsverhalten des erfindungsgemäßen Filters wichtigen Anteil m mit relativ starken Fingerüberlappungen, in dem auch das überwiegende Maß der Umsetzung des elektrischen Signals in die akustische Oberflächenwelle erfolgt. Relativ weitgehend entspricht dieser mittlere Anteil 31 insoweit demjenigen, was auch bei einem bekannten Wandler 12, 13 vorliegend ist.

Die beiden sich an den Anteil 31 anschließenden Anteile 32 und 32' dienen filtertechnisch vor allem der Formgebung der Durchlaßkurve, wie dies für sich genommen hinlänglich bekannt ist. Das Filterdesign eines solchen Eingangswandlers wird auch bei der Erfindung mit Hilfe verfügbarer Optimierungsalgorithmen erstellt, denen die bei der Erfindung jedoch anderen Randbedingungen gegeben werden. Dies führt dann zu dem neuen Filterdesign, das sich vom Stand der Technik erfindungswesentlich unterscheidet.

Die Figur 4 gibt die Mäanderstrukturen der Fingerüberlappungen der Figur 3 wieder, wie sie in dem mittleren Anteil 31 und den beiden Randanteilen 32 und 32' des Designs eines erfindungsgemäß vorgesehenen "Doppelfunktions-"Eingangswandlers" sich ergeben bzw. vorliegen.

Wie auch aus der Mäanderstruktur für den Fachmann ohne weiteres ersichtlich, ist das Gebiet m dasjenige der starken Überlappungen der digital angeordneten Wandlerfinger. Mit a und a' sind Bereiche von Wandlerfingern bezeichnet, die in den Anteilen 32 und 32' der Figur 3 liegen. Die Wandlerfinger des Bereiches a haben jeweils relativ geringe Finger-Überlappungslängen mit den hier in den Bereichen b und c vorgesehenen weiteren Wandlerfingern des Wandlers 2. Entsprechendes gilt für die Überlappung der Wandlerfinger des Bereiches a' mit den Wandlerfingern der Bereiche b' und c'.

Eine Besonderheit bilden bei der Erfindung auch die Wandlerfinger der Bereiche d und e im an sich mittleren Anteil 31 des erfindungsgemäßen doppelfunktionellen Eingangswandlers 2. Bei der Erfindung kann aber auch nur ein einziger solcher Bereich (d oder e) vorgesehen sein. Für die Erstellung des Designs des erfindungsgemäßen Wandlers kann es aber von Vorteil sein, wie beim Beispiel zwei solche Bereiche d und e vorzugeben.

In die Figur 4 sind, und zwar gestrichelt angegeben, Sammelschienen bzw. Busbars eingetragen, die der jeweiligen Potentialzuführung der Wandlerfinger der einzelnen Bereiche dienen. Durch entsprechenden Potentialanschluß an die Sammelschiene 41 können alle Wandlerfinger des Bereiches a mit diesem Potential beaufschlagt werden. Gleiches gilt für die Sammelschiene 41' des Bereiches a'. Mit 42 und 43 sind die jeweiligen Sammelschienen der Bereiche b, b' bzw. c, c' bezeichnet. Zu den Bereichen d und e gehören die Sammelschienen 44 bzw. 45.

Um Mißverständnisse zu vermeiden sei darauf hingewiesen, daß entlang der in Figur 4 oberen Kante einerseits und unteren Kante andererseits der dargestellten Struktur in der Figur 3 sich noch weitere Fingerbereiche f und f ' anschließen. Wie aus Figur 3 ersichtlich, sind aber diese Bereiche f und f ' frei von jeglichen Fingerüberlappungen und sie dienen der Egalisierung der Ausbreitung der akustischen Welle in der Oberfläche des Substratplättchens. Daran ändert auch der Umstand nichts, daß die Finger des Bereiches d sich in Fingern des Bereiches f fortsetzen. Gleiches gilt sinngemäß für die Bereiche e und f '.

Zur Kennzeichnung des erfindungsgemäßen Wandlers, der hier als Eingangswandler 2 eines Filters verwendet ist, gegenüber dem Stand der Technik, eignet sich in besonderem Maße die Beschreibung der Eigentümlichkeiten der bei einem erfindungsgemäßen Wandler vorliegenden mehreren Mäander-Polygonzüge (im folgenden als Mäanderkurven bezeichnet) der oben schon einmal erwähnten Mäanderstruktur.

Eine Eigentümlichkeit der Erfindung ist, daß ein erfindungsgemäßer Wandler in seinem schon oben erwähnten (im wesentlichen) mittleren Bereich 31 zusätzlich zu der Mäanderkurve 61 des mittleren Gebietes m wenigstens noch eine weitere Mäanderkurve 64 und/oder 65 aufweist. Bei den bekannten einschlägigen Wandlern des Standes der Technik gibt es nur eine einzige Mäanderkurve der interdigitalen Überlappungen. Das Beispiel der Figuren 3 und 4 umfaßt im mittleren Bereich 31 drei derartige Mäanderkurven 61, 64 und 65, die, wie speziell aus Figur 4 ersichtlich, sich mit ihren Hauptrichtungen 361, 364 und 365 im wesentlichen in Richtung der Hauptausbreitungsrichtung x der Welle, bezogen auf diese Ausbreitungsrichtung x seitlich nebeneinanderliegend positioniert, erstrecken. Eine weitere Eigentümlichkeit der Mäanderstruktur des Designs des erfindungsgemäßen Wandlers 2 ist das Vorliegen wenigstens eines Verzweigungspunktes 51, 51' im Zuge (bzw. am einen oder an beiden Enden) der Mäanderkurve 61. Wie insbesondere aus Figur 4 ersichtlich ist, setzt sich die Mäanderkurve 61 im Bereich 32 vom Verzweigungspunkt 51 ab in zwei weiteren Mäanderkurven 62 und 63 fort. Im Verzweigungspunkt 51' setzt sich beim Beispiel der Figur 4 (und Figur 3) die Mäanderkurve 61 mit den Mäanderkurven 62' und 63' fort. Der erfindungsgemäße Eingangswandler 2 eines Filters hat, wie schon erwähnt, eine Mäanderstruktur mit mindestens einem solchen Verzweigungspunkt 51 oder 51'. Die Mäanderkurve 62 kennzeichnet die Überlappungen der Finger des Bereiches a mit denen des Bereiches b und die Mäanderkurve 63 diejenigen des Bereiches a mit denjenigen des Bereiches c. Sinngemäß kennzeichnen die Mäanderkurven 62', 63' die Überlappungen der Finger des Bereiches a' mit denen des Bereiches b' bzw. c'.

Aus der Verzweigung im Punkt 51 ergibt sich die bei der Erfindung vorliegende Besonderheit der Bereiche b und c. Entsprechendes gilt für eine Verzweigung im Punkt 51' für die Bereiche b' und c'.

Bei den Eingangswandlern 12, 13 der Figur 2 des Standes der Technik hat eine der Figur 4 entsprechende Mäanderstruktur wesentlich anderes Aussehen. Insbesondere gibt es dort keine weitere seitliche benachbart vorhandene Mäanderkurve und es treten dort keine Punkte auf, in denen Verzweigungen der Mäanderkurven der Fingerüberlappungen vorliegen.

Zu den Bereichen b, b' einerseits und c, c' andererseits ist darauf hinzuweisen, daß sie wesentliche Bedeutung für die Fingerstruktur des erfindungsgemäßen Wandlers 2 haben.

Als eine Randbedingung für die Anwendung des Optimierungsalgorithmus dienen die Kriterien, die den normierten Funktionen sowohl dem Eingangssignal der einen Norm als auch dem Eingangssignal der anderen Norm zugehören. Der weiteren Anpassung des mittleren Gebietes m an die eine Norm, d.h. als Filterfunktion des von der einen Norm vorgeschriebenen Kanalfilters, dienen die Überlappungen mit den Fingern des Bereiches d. Sinngemäß hat der Bereich e entsprechende Bedeutung für die andere Übertragungsfunktion, z.B. als Kanalfilter der anderen Norm. Den Bereichen d und e kommt eine wichtige Funktion als Anpassungselemente für das erfindungsgemäße Filter zu.

Ein erfindungsgemäßer Wandler 2 mit der erfindungsgemäßen Doppelfunktion wird in der Praxis beispielsweise und vorteilhaft wie folgt betrieben. Als Filter der eine Übertragungsfunktion, also beispielsweise als Fernseh-Kanalfilter der einen Norm, werden die Wandlerfinger der Bereiche a, a', d und e auf ein vorgegebenes Potential gelegt, z.B. auf Massepotential. Für diese Übertragungsfunktion werden außerdem die Bereiche c, c' zusätzlich mit den vorgenannten Bereichen verbunden und als Gegenpol für den Anschluß des einen Eingangssignals I verbleiben die Wandlerfinger des Bereiches b, b'. Für die zweite Übertragungsfunktion bleiben die Bereiche a, a', d und e wieder miteinander verbunden, z.B. wiederum auf Massepotential und mit den Wandlerfingern dieser Bereiche werden nunmehr die Wandlerfinger des Bereiches b, b' verbunden. Als Gegenpol wirken jetzt die Wandlerfinger des Bereiches c, c', denen das andere Eingangssignal II zugeführt wird. Die eine Hälfte der Wandlerfinger des Bereiches m ist mit dem Bereich b, b', die andere Hälfte mit dem Bereich c, c' verbunden.

Abgesehen von der interdigitalen Wandlerwirkung im mittleren Gebiet m des Eingangswandlers 2 des Filters liegt also für die eine Übertragungsfunktion ein weiterer Schwerpunkt interdigitaler Wirkung bei den Überlappungen der Wandlerfinger des Bereiches b, b' mit allen seinen Nachbarbereichen vor. Für die andere Übertragungsfunktion liegt dieser zusätzliche Schwerpunkt bei den Überlappungen der Wandlerfinger des Bereiches c, c' mit den Wandlerfingern seiner Nachbarbereiche. Diesem Erfindungsgedanken wird bei der Erstellung des Filterentwurfs bzw. des Wandlerdesigns bei Anwendung des Optimierungsalgorithmus Rechnung getragen. Dabei sind die Bereiche b, b' einerseits und c, c' andererseits, und zwar insbesondere der jeweilige Bereichsanteil, der zwischen den starken Überlappungen des Gebietes m und dem Bereich d einerseits bzw. dem Bereich e andererseits liegt, verfügbarer Variationsbereich.

Die Bereiche d und e sind auch als Bereiche mit solchen Überlappungen zu verstehen, die den gemeinsamen in Doppelfunktion wirkenden Wandler des Doppelfilters an die eine Übertragungsfunktion einerseits und an die andere Übertragungsfunktion andererseits anpassen. Durch die oben angegebene Wahl der Polung der Anschlüsse der Bereiche bb' bzw. cc' wird für die jeweilige Übertragungsfunktion I, II der jeweilige Bereich d oder e dieser Korrekturüberlappungen zusammen mit der jeweiligen Hälfte der Wandlerfinger des Bereiches m mit dem einen bzw. mit dem anderen Eingangssignal beaufschlagt.

Hergestellt wird ein mit der Erfindung ausgestaltetes Doppelfilter mit den üblichen Methoden der Entwicklung und Produktion von Oberflächenwellenfiltern. Vorzugsweise sind auf dem Substratplättchen 1 zusätzlich auch die elektrischen Potentialanschlüsse 141 bis 145 für die Bereiche a bis e bzw. deren Sammelschienen 41 bis 45 vorgesehen. Diese Anschlüsse werden in bekannter Weise mit sehr dünnen Bonddrähten oder dergleichen kontaktiert. Bei einer Betriebsart eines Wandlers der Erfindung ist der Anschluß 142 der Sammelschiene 42 bzw. des Bereiches b, b' der Eingang E1 für die eine Übertragungsfunktion bzw. für das eine Eingangssignal I. Entsprechend ist der Anschluß der Sammelschiene 43 bzw. des Bereiches c, c' der Anschluß E2 der anderen Übertragungsfunktion bzw. des zweiten Eingangssignals II. Es liegen, wie schon oben erwähnt, die Bereiche a, a', d und e, d.h. die Sammelschienen 41, 41', 44 und 45 stets auf gemeinsamem gleichem Potential, vorzugsweise auf Masse. Wird das Filter mit dem Eingangssignal E1 beaufschlagt, muß der andere Eingang E2 mit dem Potential der Bereiche a, a', d und e verbunden werden. Wird umgekehrt der Eingang E2 mit dem (anderen) Eingangssignal beaufschlagt, ist der Eingang E1 mit dem Potential dieser weiteren vier Bereiche zu verbinden. Eine solche, vorzugsweise elektronisch ausgeführte Schalterfunktion ist zusätzlich bei der Erfindung als externes Betriebsmittel des Doppelfilters vorzusehen.

Ein Beispiel einer weiteren Betriebsart des Wandlers ist, für die eine Übertragungsfunktion das erste Eingangssignal I an die miteinander verbundenen Bereiche c, c' und a' anzulegen und die Bereiche a, b, b', d und e miteinander verbunden auf gleiches Potential, z.b. Masse, zu legen. Für die zweite Übertragungsfunktion des Filters wird das zweite Eingangssignal II an die Bereiche b, b' und a angelegt und die Bereiche a', c, c', d und e werden auf gleiches Potential, z.B. Masse, gelegt. Auch bei dieser Betriebsweise sind die Überlappungen des Bereiches d und die des Bereiches e mit dem jeweils benachbarten Bereich maßgeblich für die eine und für die andere der Übertragungsfunktionen des erfindungsgemäßen Wandlers mit Doppelfunktion beteiligt.

Bei diesen beiden Beispielen mit unsymmetrischem Betrieb des Filters können die Anschlüsse von Eingangssignal (I bzw. II) und "gleiches Potential" auch vertauscht sein.

Das erfindungsgemäße Filter kann auch symmetrisch betrieben werden, d.h. ein Pol des jeweiligen Eingangssignals wird wie oben angegeben angeschlossen und der andere Pol wird an den Anschluß "gleiches Potential" gelegt.

Die Erfindung führt somit zu einem Einspur-Inline-Filter und ist bevorzugt als vorteilhafte Substitution zweier Kanalfilter bekannter Ausführungen (Figur 2) geeignet.

Voranstehend ist der erfindungsgemäße Wandler mit Doppelfunktion als Eingangswandler eines Filters in Oberflächenwellentechnik beschrieben. Je nachdem welches Eingangssignal dem Wandler an seinen Eingängen E1 und E2 zugeführt wird, erzeugt der erfindungsgemäße Wandler im Substrat eine eindeutige, d.h. jeweils die gleiche akustische Welle, die im Ausgangswandler in jeweils das gleiche elektrische Ausgangssignal umgesetzt wird. Die Eingänge E1 und E2 sind dabei die, wie oben beschrieben, jeweiligen Kombinationen der Anschlüsse an die einzelnen Bereiche a bis e.

Der erfindungsgemäße Wandler kann auch zur Erzeugung eines jeweils gleichen elektrischen (Ausgangs-)Signals verwendet werden, wobei diesem dann als Ausgangswandler wirksamen erfindungsgemäßen Wandler zeitlich alternativ zwei verschiedene akustische Wellen zugeführt werden. Ein Beispiel hierfür ist ein Filter nach der Figur 1, bei dem dem Wandler 4 dann ein bestimmtes vorgegebenes elektrisches Signal als Eingangssignal zugeführt wird, dieser Wandler eine akustische Welle im Substrat 1 erzeugt und im Wandler 2, der dann Ausgangswandler ist, zwei verschiedene elektrische Signale, die dann Ausgangssignale sind, erzeugt werden. Diese zwei verschiedenen Signale können wiederum zeitlich alternativ an dem Wandler 2 abgenommen werden, und zwar das eine Signal bei Vorliegen der einen Anschlußkombination und das andere Signal bei Vorliegen der anderen Anschlußkombination, nämlich so wie diese Anschlußkombinationen der oben beschriebenen Betriebsweisen angegeben sind.

Unter Oberflächenwellen sind im Sinne der Erfindung nicht nur akustische Wellen des Typs der Raleigh-Wellen und Bleustein-Gulyaiv-Wellen, sondern auch Surface Scimming Bulk-Waves (SSB-Wellen), Leaky-Oberflächenwellen, Low-Waves und dergleichen Wellen zu verstehen.

## Patentansprüche

1. Oberflächenwellenwandler mit einer Interdigitalstruktur auf piezoelektrischem Material,
mit einer Interdigitalstruktur, deren Mäanderstruktur der Verteilung der Fingerüberlappungen,
zusätzlich zu einer prinzipiell vorhandenen ersten Mäanderkurve (61) eines Wandlers wenigstens eine weitere Mäanderkurve (64 und/oder 65) interdigitaler Überlappungen, die sich richtungsmäßig dieser ersten Mäanderkurve (61) im wesentlichen parallel verlaufend erstreckt, aufweist und wenigstens eine Verzweigung (51 und/oder 51') dieser ersten Mäanderkurve (61) aufweist, in der sich diese erste Mäanderkurve (61) mit zwei Verzweigungsästen als Mäanderkurven (62, 63 und/oder 62', 63') fortsetzt.

2. Oberflächenwellenwandler nach Anspruch 1,
mit einer Mäanderstruktur mit zwei weiteren Mäanderkurven (64, 65), von denen bezogen auf die erste Mäanderkurve (61, 361), die eine zusätzliche Mäanderkurve (64) sich auf der einen Seite (364) der ersten Mäanderkurve (361) erstreckt und die andere zusätzliche Mäanderkurve (65) sich auf der dazu anderen Seite der ersten Mäanderkurve erstreckt, und mit zwei Verzweigungen (51, 51'; 62, 63 und 62', 63') der ersten Mäanderkurve (61).

3. Anwendung eines Wandlers nach einem der Ansprüche 1 oder 2 in einem Oberflächenwellenfilter als doppelt-funktionaler Eingangswandler (2) für zwei umschaltbar zeitlich alternativ zuzuführende Eingangssignale I und II zur Erzeugung eines Ausgangssignals jeweils gleicher Art/Norm.

4. Anwendung nach Anspruch 3 als Fernsehkanalfilter für Eingangssignale zweier verschiedener Normen.

5. Anwendung eines Wandlers nach einem der Ansprüche 1 oder 2 als Oberflächenwellen-Generator für zwei umschaltbar zeitlich alternativ abzugebende elektrische Signale, die mit Oberflächenwellentechnik mittels ein- und demselben elektrischen Eingangssignal des Generators zu erzeugen sind.

## Claims

1. Surface acoustic wave transducer having an interdigital structure of piezoelectric material, having an interdigital structure whose meandering structure of the distribution of the finger overlaps, in addition to a first meander curve (61), which is present in principal, of a transducer has at least one further meander curve (64 and/or 65) of interditigal overlaps, which extends such that its direction runs essentially parallel to this first meander curve (61), and has at least one fork (51 and/or 51') in this first meander curve (61), in which this first meander curve (61) continues with two fork branches as meander curves (62, 63 and/or 62', 63').

2. Surface acoustic wave transducer according to Claim 1,
having a meandering structure with two further meander curves (64, 65), of which, with respect to the first meander curve (61, 361), the one additional meander curve (64) extends on the one side (364) of the first meander curve (361), and the other additional meander curve (65) extends on the other side of the first meander curve to this, having two forks (51, 51'; 62, 63 and 62', 63') in the first meander curve (61).

3. Use of a transducer according to one of Claims 1 or 2, in a surface acoustic wave filter as a double-function input transducer (2) for two input signals I and II, which can be switchably supplied alternatively in time, in order to in each case produce an output signal of the same type/to the same Standard.

4. Use according to Claim 3, as a television channel filter for input signals to two different Standards.

5. Use of a transducer according to either of Claims 1 and 2 as a surface acoustic wave generator for two electrical signals which can be switchably emitted alternatively in time and can be produced, on the basis of surface acoustic wave technology, by means of one and the same electrical input signal to the generator.

## Revendications

1. Transducteur à onde de surface comportant une structure d'interdigitation en un matériau piézo-électrique, comportant une structure d'interdigitation dont la structure en méandre de la répartition des chevauchements de doigt, en plus d'une première courbe (61) de méandre de principe présente d'un transducteur, comporte au moins une courbe (64 et/ou 65) de méandre supplémentaire de chevauchements interdigitaux, courbe (64 et/ou 65) supplémentaire qui s'étend en direction sensiblement parallèlement à cette première courbe (61) en méandre, et comporte au moins un embranchement (51 et/ou 51') de cette première courbe (61) en méandre, dans laquelle cette première courbe (61) en méandre se poursuit par deux parties d'embranchement sous forme de courbes (62, 63 et/ou 62', 63').

2. Transducteur d'onde de surface suivant la revendication 1, comportant une structure en méandre ayant deux courbes (64, 65) en méandre supplémentaires, desquelles, par rapport à la première courbe (61, 361) en méandre, ladite une courbe (64) en méandre supplémentaire s'étend d'un côté (364) de la première courbe (361) en méandre et l'autre courbe (65) en méandre supplémentaire s'étend de l'autre côté de la première courbe en méandre, et comportant deux embranchements (51, 51' ; 62, 63 et 62', 63') de la première courbe (61) en méandre.

3. Utilisation d'un transducteur suivant l'une des revendications 1 ou 2, dans un filtre à onde à surface en tant que transducteur (2) d'entrée à double fonctionnalité pour deux signaux I et II d'entrée à envoyer en alternance dans le temps de manière à pouvoir être commutés pour la production d'un signal de sortie chaque fois de même genre/norme.

4. Utilisation suivant la revendication 3 en tant que filtre de canal de télévision pour des signaux d'entrée de deux normes différentes

5. Utilisation d'un transducteur suivant l'une des revendications 1 ou 2 en tant que générateur d'onde à surface pour deux signaux électriques à envoyer en alternance dans le temps en pouvant être commutés qui peuvent être produits par une technique d'onde de surface au moyen d'un seul et même signal d'entrée électrique du générateur.
